# EUROPÄISCHE PATENTSCHRIFT

(11) **EP 1 004 165 B1**
(45) Veröffentlichungstag und Bekanntmachung des Hinweises auf die Patenterteilung: **03.03.2004**
(21) Anmeldenummer: 99938146.0
(22) Anmeldetag: 08.06.1999
(51) Int. Cl.: H03F 1/30

(54) **AKTIVE ARBEITSPUNKTEEINSTELLUNG FÜR LEISTUNGSVERSTÄRKER**
ACTIVE OPERATING POINT REGULATION FOR POWER AMPLIFIERS
REGLAGE ACTIF DE POINTS DE FONCTIONNEMENT D'UN AMPLIFICATEUR DE PUISSANCE

(30) Priorität: 22.06.1998 DE 19827702
(43) Veröffentlichungstag der Anmeldung: 31.05.2000
(73) Patentinhaber: Infineon Technologies AG, 81669 München (DE)
(72) Erfinder: FORSTNER, Johann-Peter, D-85643 Steinhöring (DE)
(74) Vertreter: Zimmermann & Partner
(86) Internationale Anmeldenummer: PCT/DE1999/001679
(87) Internationale Veröffentlichungsnummer: WO 1999/067879

(56) Entgegenhaltungen:
- DE-A- 2 705 583
- US-A- 5 548 247
- US-A- 5 633 610

## Beschreibung

Die Erfindung betrifft eine Verstärkerschaltung umfassend mindestens einen Endstufentransistor, eine Schaltung zur Kompensation von Ruhestromdrifts und ggf. Bauelemente zur Ansteuerung des/der Endstufentransistor-s/-en.

Verstärkerschaltungen für die Hochfrequenztechnik enthalten in der Regel Endstufentransistoren, wie z.B. GaAs-MESFET's. Beispielsweise wird der Arbeitspunkt der Endstufe eines Mobiltelefons auf einen Bereich der Verstärkungskennlinie eingestellt, der im unteren Drittel des Drain-Source-Stroms I_{DS}, typischerweise bei etwa I_{DS} = 0,1 x I_{DSS}, liegt (class AB-Betrieb).

Geeignete Verstärkerschaltungen mit hohem Wirkungsgrad enthalten auf einem Chip i.d.R. mehrere MESFET's, die eine Vielzahl von länglichen Dotierungsbereichen aufweisen. Während der Herstellung kann es von Chip zu Chip bzw. von Wafer zu Wafer zu geringen fertigungsbedingten Schwankungen (z.B. durch verändernde Dotierungskonzentration) kommen, die sich in nicht genau reproduzierbaren Verstärkungskennlinien niederschlagen. Hierdurch ergibt sich die Notwendigkeit einer nachträglichen Einstellung des Ruhestroms bei jedem einzelnen Chip. Diese erfolgt durch Einstellung der sogenannten "Pinch Off"-Spannung v_{P} in einem Bereich von z.B. - 4 V bis - 2,5 V, so daß I_{DS} innerhalb eines vorgegebenen Bereichs von z.B. I_{DS} = 10 % I_{DSS} +- 10 % liegt. Eine zusätzliche Schwierigkeit liegt darin, daß der Grenzwert für den Ruhestrom im gesamten Temperaturbereich von beispielsweise -30 °C bis 80 °C eingehalten werden muß. Eine aufwendige Ruhestromoptimierung durch nachträgliche Kalibrierung der fertigen Schaltung ist daher die Regel. Eine entsprechende Kalibrierung ist jedoch kostenintensiv und aufwendig.

Eine im Stand der Technik bekannte Schaltung, die eine teilweise Stabilisierung des Ruhestroms bewirkt, ist in Fig. 3 dargestellt. Ein Bauteil, in dem diese Schaltungsanordnung verwendet wird, wird unter der Bezeichnung CGY-96 von Fa. Siemens AG vertrieben. In der Schaltung bilden Feldeffekttransistor 25, Widerstand 32 und V_{neg} 29 eine Konstantstromquelle. Drain Anschluß 26 ist über einen Widerstand an die die positive Spannung V_{con} 27 angeschlossen. Von Gate 30 besteht ebenfalls eine Verbindung zu Vneg 29. Diese Schaltungsanordnung ist über Anschluß 31 mit den Gates der Endstufenfeldeffekttransistoren 33 der Verstärkerschaltung verbunden. Sämtliche Bauteile, welche die Schaltung in Fig. 3 bilden, befinden sich auf einem in MMIC-Technologie gefertigten Chip. Die Regelschaltung zur Kontrolle des Ruhestroms ist in einem seperaten Schaltungsteil mit einem Abstand von weit mehr als 500 µm zu den Endstufentransistoren angeordnet. Nachteil dieser Anordnung ist, daß seitens des Kunden eine Kalibrierung der Verstärkerschaltung an Punkt 27 (V_{con}) vorgenommen werden muß. Ferner ist es nachteilig, daß der Drain-Strom eine nichtlineare Abhängigkeit von Spannung V_{con} 27 hat.

Eine aktive Arbeitspunkteinstellung für Leistungsverstärker ist ebenfalls aus der Druckschrift US 5 633 610 bekannt.

Aufgabe der vorliegenden Erfindung ist es nun, eine gegenüber der vorstehend beschriebenen Anordnung verbesserte Verstärkerschaltung bereitzustellen, die nicht nachträglich kalibriert werden muß und über einen deutlich erweiterten Temperaturbereich einen Ruhestrom aufweist, welcher innerhalb der vorgegebenen Grenzen liegt.

Gegenstand der vorliegenden Erfindung ist daher eine Verstärkerschaltung umfassend mindestens einen Endstufentransistor 12, eine Schaltung zur Kompensation von Ruhestromdrifts und ggf. Bauelemente zur Ansteuerung des/der Endstufentransistors/-en, welche dadurch gekennzeichnet ist, daß die Schaltung zur Kompensation von Ruhestromdrifts mindestens einen Referenzstromfeldeffekttransistor 23 mit einer Gateelektrode 22 aufweist, wobei mindestens eine Gateelektrode 22 im Bereich der Elektroden des/der Endstufentransistor-s/-en 5 angeordnet ist und sich der/die Referenzstromfeldeffekttransistor/-en auf einer gemeinsamen Chipfläche 6,8 mit dem/den Endstufentransistor/-en 12 befindet.

Der Referenzstromtransistor gemäß der vorliegenden Erfindung ist in der Weise gestaltet, daß er die äußeren sich auf den Ruhestrom einwirkenden elektrischen und physikalischen Einflüße auf die Endstufentransistoren möglichst gut nachempfindet. Vorzugweise liegt der Referenzstromtransistor auf dem gleichen elektrischen Potential wie die Endstufentransistoren.

Vorzugsweise weist die erfindungsgemäße Verstärkerschaltung einen Ruhestrom auf, der im Temperaturbereich von -30 °C bis 80 °C in einem Bereich von 10 bis 500 mA liegt.

Die Gateelektrode 22 befindet sich vorzugsweise in einem Abstand von weniger als 100 µm von der nächsten Elektrode 5 eines Endstufentransistors entfernt. Besonders bevorzugt ist die Gateelektrode 22 in einem Abstand von weniger als 50 µm angeordnet.

Als Referenzstromtransistor 23 wird ein Transistor eingesetzt, welcher vorzugsweise der Bauart des/der Endstufentransistoren 12 weitestgehend entspricht. Insbesondere sind beide Transistorenarten in GaAs-MESFET-Technologie gefertigt. Besonders zweckmäßig ist es, bei der Herstellung der Schaltung einen Teilbereich der Dotierungsbereiche des der Endstufentransistor-s/-en für den/die Referenzstromtransistor-en mitzuverwenden. D.h. daß zur Bildung eines Referenzstromtransistors ein oder mehrere Dotierungsbereiche, welche für die Eridstufentransistoren vorgesehen sind, verwendet wird.

Vorzugsweise wird der Strom des/der Referenzstromtransistors-en zur Regelung des Eingangssignals des/der Endstufentransistor-s/-en benutzt.

Die Schaltung zur Kompensation von Ruhestromdrifts ist in einer bevorzugten Ausführungsform nicht auf dem Chip 6,8 angeordnet, auf dem sich die Endstufentransistoren 12 befinden.

Vorzugsweise bildet die Schaltung zur Kompensation von Ruhestromdrifts unter Zuhilfenahme einer weitgehend konstanten Referenzspannung 13 und eines Widerstandes 14 eine dem Strom des/der Referenzstromtransistoren proportionale Spannung 20. Diese Spannung wird dann zur Regelung des Eingangssignals des/der Endstufentransistor-s/-en benutzt.

Zur Regelung des Eingangssignals des/der Endstufentransistors/-en weist die Schaltung zur Kompensation von Ruhestromdrifts bevorzugt mindestens einen Transistor 19 auf. Dieser Transistor ist besonders bevorzugt ein bipolarer Transistor, insbesondere ein PNP-Transistor in bipolarer Technologie.

Ferner weist die Schaltung zur Kompensation von Ruhestromdrifts zweckmäßigerweise eine zusätzliche Schaltungsanordnung 17, 18 auf, welche zusätzlich vorhandene Temperaturdrifts der Kompensationsschaltung kompensiert.

Ein weiterer Gegenstand der vorliegenden Erfindung ist die Verwendung der erfindungsgemäßen Verstärkerschaltung als Leistungsverstärker in Mobilfunkanlagen, wie beispielsweise Mobiltelefonen.

Es zeigen
- Figur 1: ein Beispiel für eine erfindungsgemäße. Schaltungsanordnung auf einem Chip 6, 8,
- Figur 2: eine Schaltungsanordnung gemäß der Erfindung mit dem in Fig. 1 gezeigten Schaltungsteil auf dem Chip 6, 8 und einer Kompensationsschaltung 9 und
- Figur 3: eine Schaltungsanordnung zur Anpassung des Ruhestroms basierend auf einer Konstantstromquelle gemäß dem Stand der Technik.

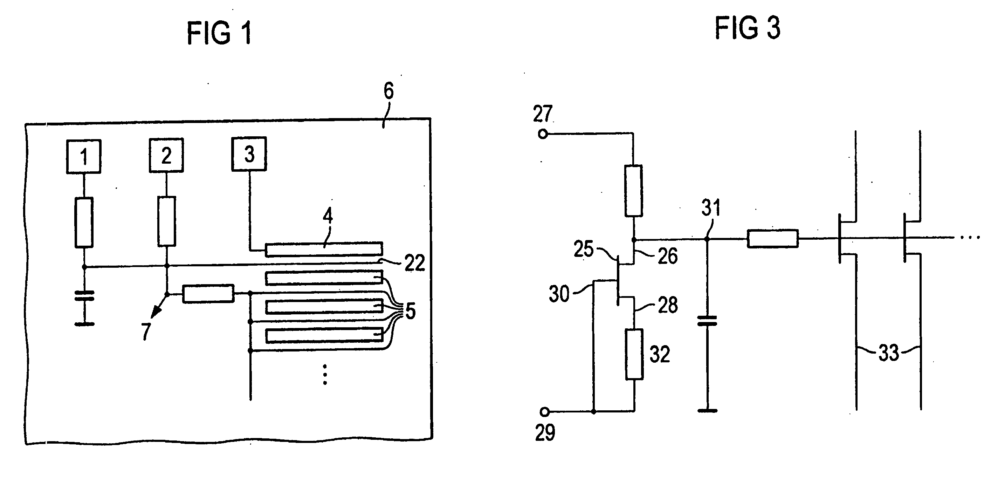

In Figur 1 ist der Hochfrequenzteil einer erfindungsgemäßen Verstärkerschaltung dargestellt. Auf Chip 6, welcher vorzugsweise ein Chip in MMIC-Technologie ist, befinden sich fingerförmige Dotierungsbereiche der Endstufentransistoren 5. Die Endstufentransistoren sind vorzugsweise HF-FET's, wie beispielsweise GaAs-MESFET's.
Weiterhin befinden sich auf dem Chip 6 Bondpads für V_{neg} 1, Gate 2 und Drain 3. V_{neg} 1 ist über einen Widerstand mit einem Kondensator und Gate 22 des Referenzstromtransistors verbunden. Bondpad 2 ist mit Gate 22 des Referenzstromtransistors über einen weiteren Widerstand verbunden. Desweiteren besteht über einen Widerstand eine Verbindung zu den Gates der Endstufentransistoren 5. Bondpad 3 ist mit Drain-Finger 4 des Referenzstromtransistors verbunden. An Schaltungspunkt 7 besteht eine Verbindung zu weiteren Gates. Der Referenzstromtransistor ist mit den einzelnen Verstärkerstufen als Stromspiegel beschaltet.

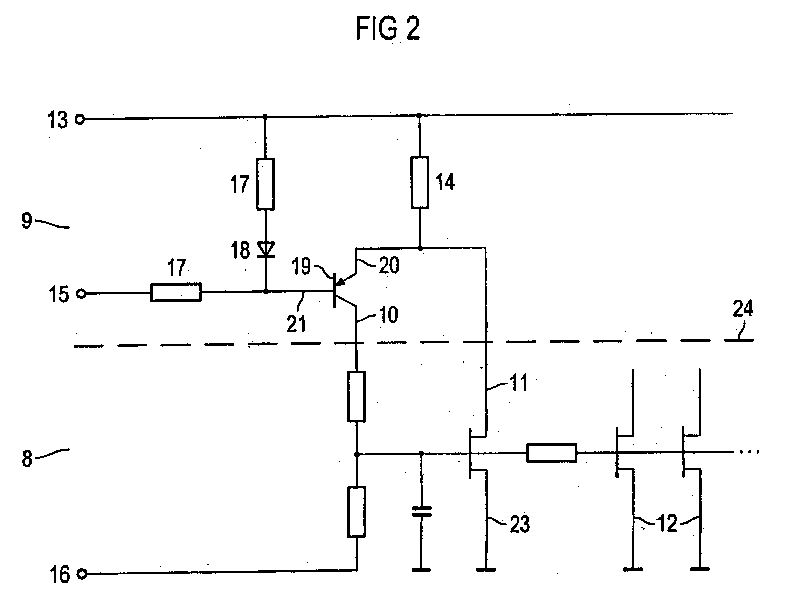

In Schaltung gemäß Figur 2 definiert Linie 24 eine räumliche und schaltungstechnische Trennung des Bereichs 8 (Chip) zu Bereich 9 (externer Schaltungsbereich).
Schaltungspunkt 10 entspricht Anschluß Gate 2 in Figur 1 und Schaltungspunkt 11 Anschluß Drain 3 in Figur 1.
An V_{ref} 13 liegt eine Spannung an, die vorzugsweise stabilisiert ist und beispielsweise bei etwa +3 V liegt. Die Schwankungen betragen zweckmäßigerweise weniger als +-5%. Das Potential an Punkt V_{con} 15 liegt im Bereich von 0 bis 2 V. An Punkt V_{neg} 16 liegt eine Spannung von etwa -4 V an. Der Widerstand R_{ref} 14 ist mit Emitter 20 des Transistors 19 und mit Referenzstromtransistor 23 (Drain) verbunden.
An R_{ref} 14 liegt beispielsweise eine Spannung von +1 V an. Die Spannung an Punkt 20 beträgt dann +2 V, die an Basis 21 +1,3 V.

Als Bauelement zur Regelung 19 läßt sich beispielsweise ein PNP-Doppeltransistors in bipolarer Technologie einsetzen. Mit Hilfe der Bauelemente 17 und 18 kann vorzugsweise eine Temperaturkompensation des Bauelements zur Regelung 19 vorgenommen werden. In diesem Fall ist V_{ref} 13 über Widerstand 17 mit Diode 18 verbunden. Von Diode 18 bestehen Verbindungen zur Basis 21 und über einen Widerstand zu V_{con} 15.

Die Kompensationsschaltung gemäß der Erfindung ermöglicht das Ausregeln eines konstanten Ruhestroms über einen weiten Temperaturbereich. Die aktuellen physikalischen Bedingungen im Bereich der Endstufentransistoren werden durch die weitgehende räumliche und geometrische Übereinstimmung des Referenzstromtransistors mit den Endstufentransistoren besonders exakt und ohne Zeitverzögerung nachempfunden. Die Schaltung bietet auch den Vorteil, daß der Referenzstromtransistor auf dem gleichen elektrischen Potential wie die Endstufentransistoren liegt.

Die erfindungsgemäße Verstärkerschaltung ist zudem vorteilhaft gegenüber bekannten Verstärkerschaltungen, da eine optimale thermische Kopplung des Referenzstromtransistors an die thermisch aktiven Endstufentransistoren vorliegt. Hinzu kommt, daß hierdurch Vorteile im dynamischen Betrieb erreicht werden.

Auf eine aufwendige Kalibrierung zur Einstellung des Ruhestroms in einen gerätespezifisch vorgegebenen Grenzwertbereich kann bei der erfindungsgemäßen Verstärkerschaltung verzichtet werden. Hierdurch kommt es zu einer Steigerung der Ausbeute bei der Waferfertigung.

Ein weiterer Vorteil der erfindungsgemäßen Verstärkerschaltung ist die Reduktion des Betrags der erforderlichen negativen Hilfsspannung.

Ferner wird durch eine lineare Abhängigkeit von I_{D} zu V_{con} eine vereinfachte Stromstellung ermöglicht.

Die erfindungsgemäße Verstärkerschaltung bietet insbesondere dann Vorteile, wenn On Chip-Widerstände eingesetzt werden, welche relativ hohen Toleranzen unterworfen sind. Entsprechende On Chip-Widerstände haben in der erfindungsgemäßen Verstärkerschaltung jedoch praktisch keinen Einfluß auf die Regelgröße.
Zusätzlich kann während der Fertigung der erfindungsgemäßen Verstärkerschaltung eine Reduktion des zur Fertigung erforderlichen Zeitaufwands erreicht werden, da eine Selektion der bei der Fertigung erforderlichen Belichtungsmasken entfallen kann.

## Patentansprüche

1. Verstärkerschaltung umfassend mindestens einen Endstufentransistor (12), eine Schaltung zur Kompensation von Ruhestromdrifts und ggf. Bauelemente zur Ansteueung des/der Endstufentransistor-s/-en,
**dadurch gekennzeichnet,**
**daß** die Schaltung zur Kompensation von Ruhestromdrifts
- mindestens einen Referenzstromfeldeffekttransistor (23) mit einer Gateleektrode (22) aufweist, wobei mindestens eine Gateelektrode (22) im Bereich der Elektroden des/der Endstufentransistor-s/-en (5) angeordnet ist und sich der/die Referenzstromfeldeffekttransistor/-en auf einer gemeinsamen Chipfläche (6, 8) mit dem/den Endstufentransistor/-en (12) befindet, wobei sich die Gateelektrode (22) in einem Abstand von weniger als 100 µm von der nächsten Elektrode (5) eines Endstufentransistors befindet; und
- eine zusätzliche Schaltungsanordnung (17, 18) aufweist, welche zusätzlich vorhandene Temperaturdrifts der Kompensationsschaltung kompensiert.

2. Verstärkerschaltung nach Anspruch 1,
**dadurch gekennzeichnet,**
**daß** die Bauart des Referenzstromtransistors (23) der Bauart der Endstufentransistoren (12) weitestgehend entspricht.

3. Verstärkerschaltung nach Anspruch 1 oder 2,
**dadurch gekennzeichnet,**
**daß** der Strom des/der Refenzstromtransistor-s-en zur Regelung des Eingangssignals des/der Endstufentransistors/-en benutzt wird.

4. Verstärkerschaltung nach mindestens einem der Ansprüche 1 bis 3,
**dadurch gekennzeichnet,**
**daß** die Schaltung zur Kompensation von Ruhestromdrifts bis auf mindestens einen Referenzstromfeldeffekttransistor (23) nicht auf dem Chip (6, 8) angeordnet ist, auf dem sich die Endstufentransistoren (12) befinden.

5. Verstärkerschaltung nach mindestens einem der Ansprüche 1 bis 4,
**dadurch gekennzeichnet,**
**daß** die Schaltung zur Kompensation von Ruhestromdrifts unter Zuhilfenahme einer weitgehend konstanten Referenzspannung (13) und eines Widerstandes (14) eine dem Strom des/der Referenzstromtransistor-s-en proportionale Spannung (20) bildet, welche zur Regelung des Eingangssignals des/der Endstufentransistor-s/-en benutzt wird.

6. Verstärkerschaltung nach mindestens einem der Ansprüche 1 bis 5,
**dadurch gekennzeichnet,**
**daß** die Schaltung zur Kompensation von Ruhestromdrifts zur Regelung des Eingangssignals des/der Endstufentransistor-s/en mindestens einen Transistor (19) in bipolarer Technologie aufweist.

7. Verwendung der Verstärkerschaltung nach Anspruch 1 in Mobilfunkanlagen

## Claims

1. Amplifier circuit comprising at least one output stage transistor (12), a circuit for compensating for quiescent current drifts and optionally components for driving the output stage transistor(s),
**characterized in that**
the circuit for compensating for quiescent current drifts
- has at least one reference current field effect transistor (23) having a gate electrode (22), at least one gate electrode (22) being arranged in the region of the electrodes of the output stage transistor(s) (5) and the reference current field effect transistor(s) being situated on a common chip area (6, 8) with the output stage transistor(s) (12), the gate electrode (22) being situated at a distance of less than 100 µm from the nearest electrode (5) of an output stage transistor; and
- has an additional circuit arrangement (17, 18), which compensates for temperature drifts of the compensation circuit which are additionally present.

2. Amplifier circuit according to Claim 1,
**characterized in that**
the design of the reference current transistor (23) corresponds to the greatest possible extent to the design of the output stage transistors (12).

3. Amplifier circuit according to Claim 1 or 2,
**characterized in that**
the current of the reference current transistor(s) is used to regulate the input signal of the output stage transistor(s).

4. Amplifier circuit according to at least one of Claims 1 to 3,
**characterized in that**
the circuit for compensating for quiescent current drifts, except for at least one reference current field effect transistor (23), is not arranged on the chip (6, 8) on which the output stage transistors (12) are situated.

5. Amplifier circuit according to at least one of Claims 1 to 4,
**characterized in that**
the circuit for compensating for quiescent current drifts forms, with the aid of a largely constant reference voltage (13) and a resistor (14), a voltage (20) which is proportional to the current of the reference current transistor(s) and is used to regulate the input signal of the output stage transistor(s).

6. Amplifier circuit according to at least one of Claims 1 to 5,
**characterized in that**,
in order to regulate the input signal of the output stage transistor(s), the circuit for compensating for quiescent current drifts has at least one transistor (19) using bipolar technology.

7. Use of the amplifier circuit according to Claim 1 in mobile radio systems.

## Revendications

1. Circuit amplificateur comprenant au moins un transistor (12) d'étage d'extrémité, un circuit de compensation de dérives de courant de repos et, le cas échéant, des composants de commande du transistor d'étage d'extrémité ou des transistors d'étage d'extrémité,
**caractérisé en ce que**
le circuit de compensation de dérives du courant de repos
- a au moins un transistor (23) à effet de champ à courant de référence ayant une électrode (22) de grille, au moins une électrode (22) de grille étant disposée dans la partie des électrodes du ou des transistor(s) (5) d'étage d'extrémité et le ou les transistor(s) à effet de champ à courant de référence se trouvent sur une surface (6, 8) de puce commune avec le ou les transistor(s) (12) d'étage d'extrémité, l'électrode (22) de grille se trouvant à une distance de moins de 100 µm de l'électrode (5) la plus proche d'un transistor d'étage d'extrémité ; et
- a un circuit (17, 18) supplémentaire qui compense des dérives de température présentes supplémentairement du circuit de compensation.

2. Circuit amplificateur suivant la revendication 1,
**caractérisé en ce que**
le type de construction du transistor (23) à courant de référence correspond dans une grande mesure au type de construction des transistors (12) d'étage d'extrémité.

3. Circuit amplificateur suivant la revendication 1 ou 2,
**caractérisé en ce que**
le courant du ou des transistor(s) à courant de référence est utilisé pour réguler le signal d'entrée du ou des transistor(s) d'étage d'extrémité.

4. Circuit amplificateur suivant au moins l'une des revendications 1 à 3,
**caractérisé en ce que**
le circuit de compensation de dérives de courant de repos n'est pas disposé, à l'exception d'au moins un transistor (23) à effet de champ à courant de référence, sur la puce (6, 8) sur laquelle se trouvent les transistors (12) d'étage d'extrémité.

5. Circuit amplificateur suivant au moins l'une des revendications 1 à 4,
**caractérisé en ce que**
le circuit de compensation de dérives de courant de repos forme, à l'aide d'une tension (13) de référence qui est constante dans une grande mesure et d'une résistance (14), une tension (20) proportionnelle au courant du ou des transistor(s) à courant de référence, tension qui est utilisée pour la régulation du signal d'entrée du ou des transistor(s) d'étage d'extrémité.

6. Circuit amplificateur suivant au moins l'une des revendications 1 à 5,
**caractérisé en ce que**
le circuit de compensation de dérives du courant de repos a, pour la régulation du signal d'entrée du ou des transistor(s) d'étage d'extrémité, au moins un transistor (19) en technologie bipolaire.

7. Utilisation du circuit amplificateur suivant la revendication 1 dans des installations de téléphonie mobile.
